Europäisches Patentamt

European Patent Office

Office européen des brevets

(11) Numéro de publication: **0 085 599**
**A2**

(12) **DEMANDE DE BREVET EUROPEEN**

(21) Numéro de dépôt: **83400123.2**

(22) Date de dépôt: **19.01.83**

(51) Int. Cl.³: **H 01 L 41/22**

(30) Priorité: **29.01.82 FR 8201453**

(43) Date de publication de la demande:
**10.08.83 Bulletin 83/32**

(84) Etats contractants désignés:
**BE DE GB IT NL SE**

(71) Demandeur: **THOMSON-CSF**
**173, Boulevard Haussmann**
**F-75379 Paris Cedex 08(FR)**

(72) Inventeur: **Resneau, Jean-Claude**
**THOMSON-CSF SCPI 173, bld Haussmann**
**F-75379 Paris Cedex 08(FR)**

(72) Inventeur: **Puyhaubert, Jean**
**THOMSON-CSF SCPI 173, bld Haussmann**
**F-75379 Paris Cedex 08(FR)**

(54) Procédé de fabrication collective de transducteurs piézoélectriques, transducteurs obtenus par ce procédé, et utilisation d'un tel procédé.

(57) L'invention concerne un procédé de fabrication collective de transducteurs piézoéletriques.

Le procédé comporte à partir d'un bloc principal en matériau cristallin (30):
- une première métallisation (44) de l'une des faces du bloc principal;
- une fixation (46) de la face métallisée du bloc sur un support (40);
- une seconde métallisation (52) de la face opposée du bloc principal;
- un découpage (55) du bloc métallisé en blocs élémentaires;
- un retrait du support de fixation (40), chaque bloc élémentaire obtenu constituant un transductuer piézoélectrique.

Application à la réalisation de lignes à retards électroacoustiques.

FIG_7

EP 0 085 599 A2

1

PROCEDE DE FABRICATION COLLECTIVE DE TRANSDUCTEURS
PIEZOELECTRIQUES, TRANSDUCTEURS OBTENUS PAR CE PROCEDE
ET UTILISATION D'UN TEL PROCEDE

La présente invention se rapporte d'une manière générale aux lignes à retard électro-acoustiques à ondes de volume ou à ondes de surface, et concerne plus particulièrement un procédé de fabrication collective de transducteurs piézoélectriques utilisés pour la réalisation de telles lignes à retard.

De façon générale, une ligne à retard, par exemple à ondes de volume, comporte un milieu de propagation constitué par un matériau retardateur monocristallin, et un ou plusieurs transducteurs piézoélectriques transformant une onde électromagnétique en une onde acoustique et réciproquement, fixés sur ledit matériau retardateur.

De plus, un transducteur piézoélectrique réalisé en couches minces comporte au moins une couche piézoélectrique en matériau cristallin, une première couche métallique jouant le rôle d'électrode déposée sur l'une des faces de ladite couche piézoélectrique et destinée à être fixée sur le matériau retardateur, et une seconde couche métallique jouant le rôle de contre-électrode déposée sur la face opposée de ladite couche piézoélectrique.

Pour réaliser une ligne à retard, par exemple à ondes de volume, et en utilisant un monocristal piézoélectrique, il est connu de mettre en oeuvre un procédé consistant simultanément d'une part à fabriquer individuellement chaque transducteur piézoélectrique, et d'autre part à fixer ledit transducteur sur le matériau retardateur par une technique de soudure. Plus précisément, ce procédé comporte, pour chaque ligne à retard utilisant au moins un transducteur piézoélectrique dit soudé et réalisé à partir d'un monocristal, les opérations suivantes :

- un dressage parfait suivi d'un polissage soigné de l'une des faces du monocristal piézoélectrique, par exemple en Niobate de

0085599

2

Lithium, et de celle du matériau retardateur, par exemple en corindon, ledit monocristal et ledit matériau retardateur étant tous deux de forme par exemple parallélépipédique ; 

- une métallisation de ces deux faces par dépôts par exemple d'une couche d'accrochage de chrome et d'une couche d'or, ladite couche d'or déposée sur le monocristal constituant une électrode du transducteur ;

- une soudure par compression sous vide de la face métallisée du monocristal sur sensiblement toute la face métallisée du matériau retardateur ;

- une mise à épaisseur du monocristal par polissage mécanique de sa face opposée devant présenter un parallélisme parfait avec la face métallisée, ladite épaisseur étant liée à la fréquence de fonctionnement du transducteur, généralement de l'ordre de la demi-longueur d'onde de ladite fréquence ; et

-une métallisation partielle de la face précédemment polie du monocristal par dépôt d'une couche métallique, par exemple en aluminium, jouant le rôle de contre-électrode, le positionnement de cette dernière sur le monocristal étant déterminé par calculs.

Toutefois, un tel procédé présente des inconvénients. En effet, chaque transducteur piézoélectrique est réalisé de façon individuelle lors de la fabrication de chaque ligne à retard, ce qui augmente notablement le temps passé pour fabriquer en série de telles lignes à retard, et partant augmente considérablement le prix de revient de ces dernières. En outre, les opérations de polissage et de mise à épaisseur du monocristal piézoélectrique sont difficiles et longues à exécuter, de sorte que ces deux opérations participent pour l'essentiel au coût de fabrication de la ligne à retard. De plus, chaque transducteur est fixé par soudure sensiblement sur toute la face métallisée du matériau retardateur, signifiant donc que la surface dudit transducteur est relativement importante ; dans ces conditions, les opérations de polissage et de soudure doivent être parfaites de façon à éviter toute contrainte lors de la mise en compression, et l'opération de soudure doit de plus être réalisée avec grand soin de façon à éviter toute poussière qui pourrait provoquer une cassure du monocristal, abaissant dans ce cas le pourcentage de réussite des lignes à retard ainsi fabriquées.

La présente invention a pour but de remédier à ces inconvénients en proposant un procédé permettant de fabriquer de façon collective des transducteurs piézoélectriques de petites dimensions, qui est simple à réaliser et permet de diminuer le prix de revient de chaque transducteur fabriqué. De plus, la surface de chaque transducteur obtenu est relativement petite, de sorte que la fabrication ultérieure d'une ligne à retard ne nécessite pas une planéité et une qualité de polissage du matériau retardateur extrêmement rigoureuses.

A cet effet, l'invention a pour objet un procédé de fabrication collective de transducteurs piézoélectriques comportant chacun un corps en matériau cristallin et deux électrodes disposées respectivement sur deux faces opposées dudit corps, caractérisé en ce qu'à partir d'un bloc principal en matériau cristallin, le procédé comporte les étapes suivantes :

- une première métallisation de l'une des faces du bloc principal en matériau cristallin, formant ainsi une première électrode principale ;

- une fixation de la face métallisée du bloc principal sur une pièce formant support ;

- une seconde métallisation au moins partielle de la face opposée du bloc principal, formant ainsi une seconde électrode principale ;

- un découpage du bloc principal métallisé sur deux de ses faces opposées en blocs élémentaires de dimensions respectives données ; et

- un retrait du support de fixation, permettant ainsi d'obtenir collectivement les blocs élémentaires constituant chacun un transducteur piézoélectrique, le bloc principal découpé et la première et seconde électrodes principales découpées constituant respectivement le corps et les deux électrodes de chaque transducteur ainsi obtenu.

On comprend qu'ainsi le découpage d'un bloc cristallin de grande surface, une fois métallisé sur deux de ses faces opposées, et fixé sur un support intermédiaire, permettra d'obtenir rapidement et collectivement une pluralité de transducteurs piézoélectriques de petites dimensions se présentant sous forme de "puces".

L'invention vise également une utilisation du procédé selon l'invention, à la fabrication de lignes à retards électro-acoustiques comportant chacune un milieu de propagation sur lequel est fixé au moins un transducteur piézoélectrique transformant une onde électromagnétique en une onde acoustique et réciproquement, caractérisée en ce que ledit procédé comporte de plus les étapes suivantes :

- une métallisation d'au moins une face du milieu de propagation sur laquelle est destiné à être fixé le transducteur ;

- un repérage sur la face métallisée du milieu de propagation de l'emplacement du transducteur de façon à obtenir les caractéristiques désirées de la ligne à retard ; et

- un soudage de la première électrode du transducteur obtenu sur la face métallisée du milieu de propagation, à l'emplacement repéré, permettant ainsi d'obtenir la ligne à retard électroacoustique.

On comprend qu'avantageusement les matériaux retardateurs constituant les différents milieux de propagation des lignes à retard pourront être traités par plusieurs unités à la fois, ce qui abaissera le prix de revient de chacune desdites lignes fabriquées.

D'autres caractéristiques et avantages de l'invention apparaîtront mieux dans la description détaillée qui suit et se réfère aux dessins annexés, donnés uniquement à titre d'exemple, et dans lesquels :

- la figure 1 représente le schéma du procédé de fabrication collective de transducteurs selon l'invention ;

- la figure 2 représente le schéma de la fabrication d'une ligne à retard, après obtention des transducteurs par le procédé selon l'invention ;

- les figures 3a, 3b, 4 à 7 représentent les différentes étapes du procédé de fabrication collective de transducteurs selon l'invention ;

- la figure 8 représente un premier mode de réalisation d'un transducteur selon l'invention ;

- la figure 9 représente un second mode de réalisation d'un transducteur selon l'invention ; et

- les figures 10 à 12 représentent les différentes étapes de la fabrication d'une ligne à retard du type réflexion comportant un transducteur selon l'invention.

Sur ces différentes figures, les mêmes références se rapportent aux mêmes éléments.

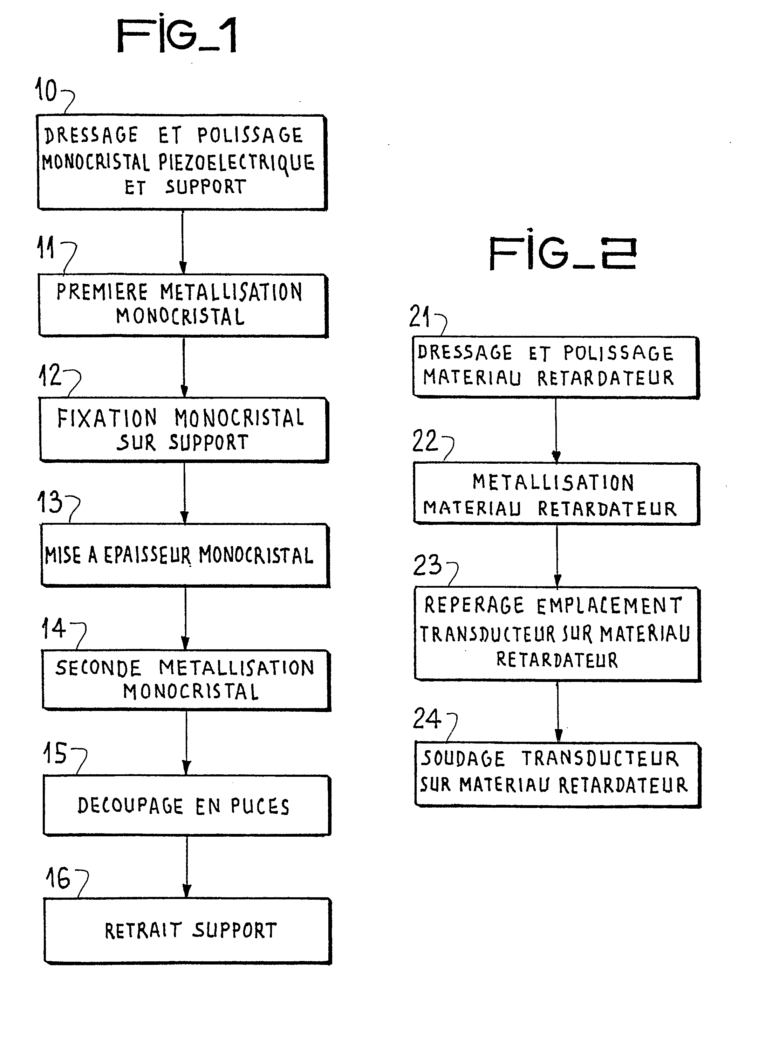

On a donc indiqué sur la figure 1 les différentes étapes de la fabrication collective, conforme à l'invention, de transducteurs piézoélectriques réalisés en couches minces et comportant chacun un corps en matériau cristallin et deux électrodes disposées respectivement sur deux faces opposées dudit corps.

La première étape (10) consiste, à partir d'un bloc principal en matériau cristallin, par exemple de forme parallélépipédique, et de grandes dimensions, et à partir d'une pièce formant support, par exemple de forme parallélépipédique, à dresser puis polir l'une des faces du bloc cristallin et du support.

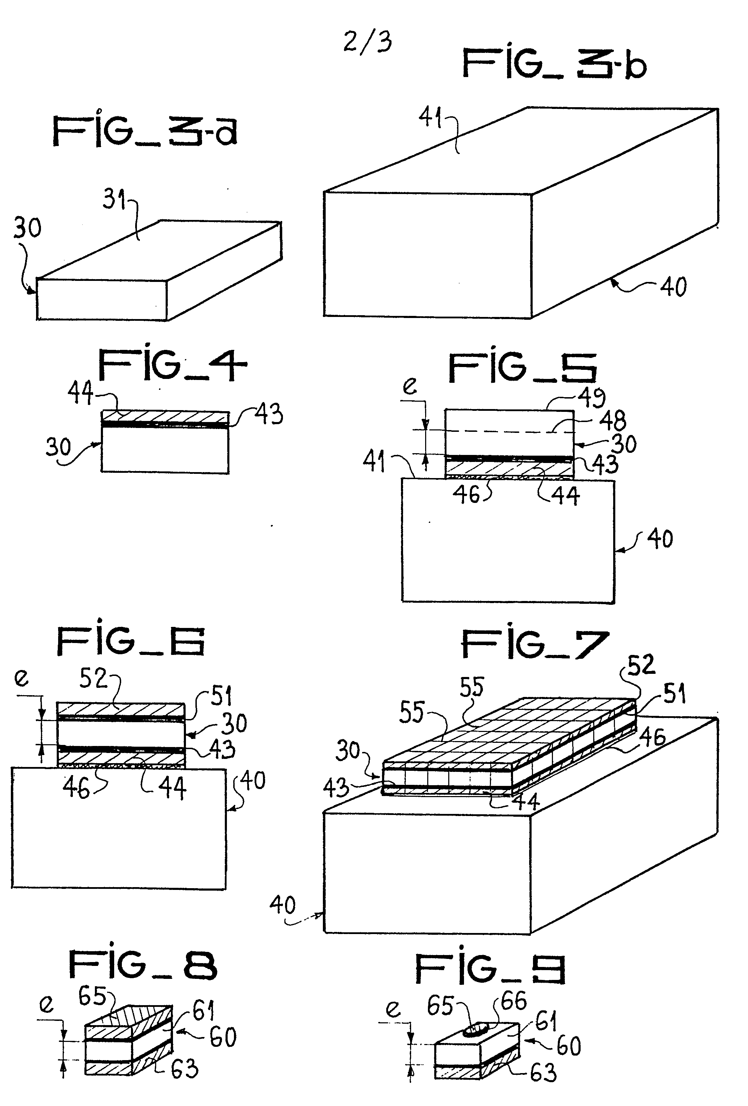

On a représenté en 30 sur la figure 3a le bloc principal constitué par un monocristal, tel que par exemple du Niobate de Lithium, ou par un polycristal, dont l'une des faces, telle que 31, est dressée, c'est-à-dire taillée de façon plane, et polie.

On a représenté en 40 sur la figure 3b le support, par exemple en verre, dont l'une des faces, telle que 41, est également dressée et polie.

La seconde étape (11, figure 1) consiste à métalliser le bloc cristallin, de façon à former une première électrode principale.

Cette métallisation, représentée sur la figure 4, consiste en un dépôt d'une couche d'accrochage 43, par exemple de chrome, d'épaisseur de l'ordre de 200 Å, sur toute la face polie du bloc monocristallin 30, et en un dépôt d'une couche 44, par exemple d'or, d'épaisseur de l'ordre de 1000 Å, ladite couche d'or 44 constituant la première électrode principale. Les deux couches 43 et 44 sont déposées par exemple par pulvérisation cathodique sous vide.

L'étape suivante (12, figure 1) consiste à fixer la face métallisée du bloc cristallin sur le support.

Cette fixation, représentée sur la figure 5, consiste par exemple en un collage de la face métallisée du bloc monocristallin 30 sur la face polie du support 40, à l'aide d'une substance susceptible de se désagréger après durcissement, telle que par exemple une mince couche de cire 46.

L'étape suivante (13, figure 1) consiste à mettre à épaisseur le bloc cristallin fixé sur le support.

Cette mise à épaisseur, représentée par les pointillés 48 sur la figure 5, consiste par exemple en un polissage mécanique de la face 49 du bloc monocristallin 30 qui est opposée à celle précédemment métallisée. L'obtention de l'épaisseur $e$ du bloc monocristallin 30 est déterminée en fonction de la fréquence de fonctionnement du transducteur. Habituellement, l'épaisseur est de l'ordre de la demi-longueur d'onde de ladite fréquence de fonctionnement.

Dans certains cas, le polissage mécanique est suivi d'une érosion ionique permettant de parfaire ce polissage et de régler avec précision l'épaisseur du bloc monocristallin, notamment lorsque celle-ci doit être inférieure à 5 µm.

L'étape suivante (14, figure 1) consiste à métalliser la face précédemment polie du bloc cristallin, de façon à former une seconde électrode principale.

Cette métallisation, représentée sur la figure 6, consiste en un dépôt d'une couche d'accrochage 51, par exemple de chrome, d'épaisseur de l'ordre de 200 Å, sur toute la face polie du bloc monocristallin 30, et en un dépôt d'une couche 52, par exemple d'or, d'épaisseur de l'ordre de 1000 Å, ladite couche d'or 52 constituant la seconde électrode principale. Les deux couches 51 et 52 sont déposées par exemple par pulvérisation cathodique sous vide.

On notera que les deux couches 51 et 52 pourraient être remplacées par une unique couche d'aluminium déposée par évaporation ou par pulvérisation cathodique sous vide, sur toute la face polie du bloc monocristallin 30, sans sortir du cadre de l'invention.

Selon une variante de cette même étape, la métallisation par dépôt soit d'une couche de chrome et d'une couche d'or, soit d'une seule couche d'aluminium, est réalisée partiellement sur la face polie du bloc monocristallin 30 à l'aide par exemple d'un masque en forme de trame, permettant ainsi de limiter ladite métallisation en des endroits déterminés du bloc monocristallin. Cette métallisation partielle a pour avantage d'éviter tout court-circuit entre les deux électrodes constituées.

On notera que la seconde électrode principale pourrait également être réalisée par photolithogravure, sans sortir du cadre de l'invention.

L'étape suivante (15, figure 1) consiste à découper le bloc cristallin métallisé sur deux de ses faces opposées en blocs élémentaires de dimensions respectives données.

Ce découpage, représenté par les traits 55 sur la figure 7, est réalisé par exemple à l'aide d'une scie diamantée permettant ainsi d'obtenir collectivement, à partir du bloc monocristallin 30, une pluralité de pavés ou "puces" métallisés, constituant chacun un transducteur piézoélectrique.

L'étape suivante (16, figure 1) consiste à retirer le support de fixation de façon à récupérer chaque puce obtenue par découpage.

Ce retrait du support 40 consiste par exemple en un chauffage de la couche de cire 46 de manière à faire fondre cette dernière. Dans le cas où la substance de fixation est par exemple une colle, il suffit de dissoudre celle-ci avec un solvant approprié.

8

La figure 8 représente un premier mode de réalisation d'une puce 60 obtenue après découpage du bloc cristallin métallisé et après retrait du support. Cette puce 60 constitue un transducteur piézoélectrique complet comportant un corps monocristallin 61, d'épaisseur $\underline{e}$, une électrode en or 63 et une contre-électrode en or 65 déposée sur toute la face supérieure du corps monocristallin 61.

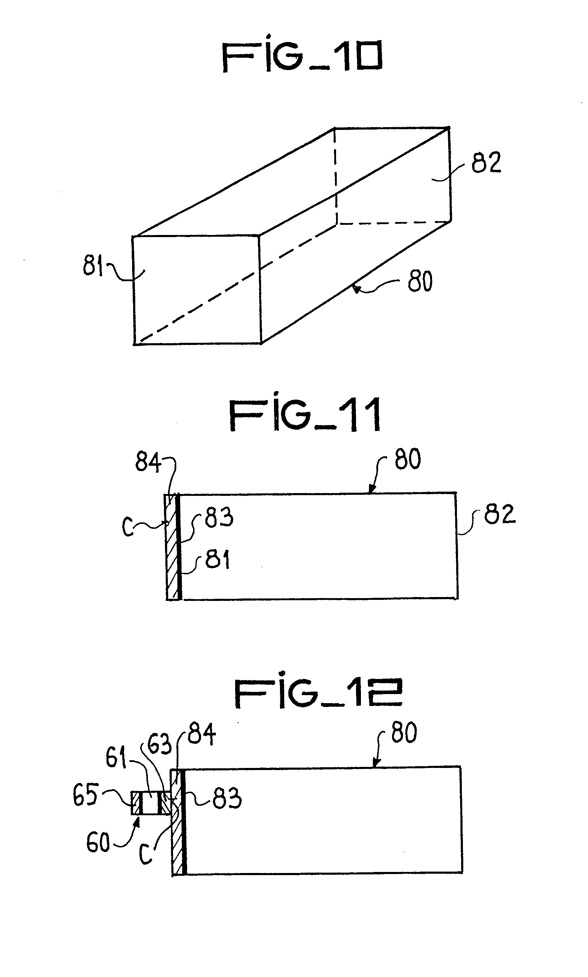

La figure 9 représente une variante de la puce 60, dans laquelle la contre-électrode en or 65, avec sa couche d'adhérence de chrome 66, sont déposées partiellement en un endroit déterminé de la face supérieure du corps monocristallin 61.

A titre d'exemple, à partir d'un monocristal de 10 mm de longueur et de 10 mm de largeur, il est possible d'obtenir de l'ordre de 1000 puces formant transducteurs de 10 ou 20 $\mu$m d'épaisseur. Pour des épaisseurs plus importantes, un monocristal de 20 mm de longueur et de 20 mm de largeur permet d'obtenir plus de 4000 puces.

Ainsi, la fabrication collective des transducteurs piézoélectriques en forme de puces permet de réduire de façon importante le prix de revient de chaque transducteur obtenu.

On a indiqué sur la figure 2 les différentes étapes de la fabrication d'une ligne à retard électro-acoustique, à ondes de volume ou de surface, comportant un milieu de propagation en un matériau retardateur sur lequel est fixé au moins un transducteur piézoélectrique du type représenté en 60 sur les figures 8 ou 9 et obtenu par mise en oeuvre du procédé de fabrication collective selon l'invention, ledit transducteur transformant une onde électromagnétique en une onde acoustique et réciproquement.

Pour une ligne à retard fonctionnant en réflexion, un seul transducteur est fixé sur l'une des faces terminales du matériau retardateur, tandis que pour une ligne à retard fonctionnant en transmission, deux transducteurs sont fixés soit respectivement sur les deux faces terminales opposées du matériau retardateur, soit sur une même face terminale du matériau retardateur.

9

La première étape (21, figure 2) consiste, pour une ligne à retard du type réflexion, ou pour une ligne à retard du type transmission dont les deux transducteurs sont disposés sur une même face, à dresser puis polir l'une des faces terminales du matériau retardateur sur laquelle est destiné à être fixé le ou les transducteurs piézoélectriques. L'autre face terminale du matériau retardateur est également dressée et polie pour assurer la réflexion de l'onde acoustique suivant un chemin déterminé à l'avance.

La figure 10 représente un matériau retardateur 80, tel par exemple du corindon, taillé par exemple sous forme parallélépipédique, et dont les faces terminales 81 et 82 sont dressées et polies.

La seconde étape (22, figure 2) consiste à métalliser l'une des faces terminales polies du matériau retardateur.

Cette métallisation, représentée sur la figure 11, consiste en un dépôt d'une couche d'accrochage 83, par exemple de chrome, d'épaisseur de l'ordre de 200 Å, sur la face polie, telle que 81, du matériau retardateur 80, et en un dépôt d'une couche 84, par exemple d'or, d'épaisseur de l'ordre de 1000 Å. Les deux couches 83 et 84 sont déposées par exemple par pulvérisation cathodique sous vide.

Bien entendu, dans le cas d'une ligne à retard du type transmission dont les deux transducteurs sont destinés à être fixés respectivement sur les deux faces terminales opposées du matériau retardateur, cette seconde étape consiste à métalliser les deux faces opposées polies dudit matériau retardateur.

On notera qu'avantageusement plusieurs dizaines de matériaux retardateurs peuvent subir en même temps les différentes opérations de dressage, polissage et métallisation.

L'étape suivante (23, figure 2) consiste, par exemple pour une ligne à retard du type réflexion, à repérer ou sélectionner, sur la face métallisée du matériau retardateur, l'emplacement du transducteur à fixer, de façon à obtenir les caractéristiques désirées de la ligne à retard, telles qu'en particulier l'atténuation et la largeur de bande.

Ce repérage de l'emplacement du transducteur est effectué à l'aide d'un micromanipulateur à deux positions comportant un système de prise de contact destiné à rechercher, de façon fonctionnelle, la position optimale du transducteur, telle que représentée en C (figure 11) sur la face métallisée 84 du matériau retardateur 80.

Dans le cas d'une ligne à retard du type transmission utilisant deux transducteurs, le repérage des emplacements respectifs des transducteurs est réalisé au moyen de deux micromanipulateurs destinés à rechercher simultanément un couple de points donnant les caractéristiques désirées de ladite ligne à retard.

L'étape suivante (24, figure 2) consiste, par exemple pour une ligne à retard du type réflexion, à souder le transducteur sur la face métallisée du matériau retardateur, à l'emplacement précédemment repéré.

La figure 12 représente le transducteur piézoélectrique tel que représenté en 60 sur la figure 8, soudé en C sur la face métallisée 84 du matériau retardateur 80, l'ensemble transducteur-matériau retardateur constituant ainsi la ligne à retard du type réflexion. Ce soudage est réalisé par exemple par thermocompression, à une température de l'ordre de 300°C, de l'électrode 63 du transducteur 60 sur la face métallisée 84 du matériau retardateur 80.

On a donc réalisé suivant l'invention un procédé de fabrication de transducteurs piézoélectriques destinés à la réalisation de lignes à retard, particulièrement efficace tant du point de vue de la fabrication en série que du point de vue de sa mise en oeuvre en raison notamment de l'emploi d'équipements très performants.

Bien entendu, l'invention n'est nullement limitée aux modes de réalisation décrits et représentés et comprend tous les équivalents techniques des moyens décrits ainsi que leurs combinaisons si celles-ci sont effectuées suivant l'esprit de l'invention et mises en oeuvre dans le cadre des revendications qui suivent.

11

REVENDICATIONS

1. Procédé de fabrication collective de transducteurs piézoélectriques (60) comportant chacun un corps en matériau cristallin (61) et deux électrodes (63, 65) disposées respectivement sur deux faces opposées dudit corps, le procédé comportant, à partir d'un bloc principal en matériau cristallin (30), les étapes suivantes :

- une première métallisation (11) de l'une des faces du bloc principal en matériau cristallin, formant ainsi une première électrode principale (44) ;

- une fixation (12) de la face métallisée du bloc principal sur une pièce formant support (40) ;

caractérisé en ce que le procédé comprend en outre les étapes suivantes :

- une mise à épaisseur (13) de la face opposée du bloc principal ;

- une seconde métallisation (14) au moins partielle de ladite face opposée du bloc principal, formant ainsi une seconde électrode principale (52) ;

- un découpage (15) du bloc principal métallisé sur deux de ses faces opposées en blocs élémentaires de dimensions respectives données ; et

- un retrait (16) du support de fixation, permettant ainsi d'obtenir collectivement les blocs élémentaires (60) constituant chacun un transducteur piézoélectrique, le bloc principal découpé et la première et seconde électrodes principales découpées constituant respectivement le corps (61) et les deux électrodes (63, 65) de chaque transducteur ainsi obtenu.

2. Procédé selon la revendication 1, caractérisé en ce que la mise à épaisseur (13) consiste en un polissage mécanique de la face opposée du bloc principal.

12

3. Procédé selon la revendication 2, caractérisé en ce que le polissage mécanique est suivi d'une érosion ionique permettant de régler avec précision l'épaisseur (e) du bloc principal.

4. Procédé selon l'une des revendications 1 à 3, caractérisé en ce qu'avant la première métallisation (11), le procédé comporte un dressage suivi d'un polissage (10) de la face du bloc principal destinée à être métallisée en premier et de la face du support sur laquelle est destiné a être fixé le bloc principal.

5. Procédé selon l'une des revendications précédentes, caractérisé en ce que la première métallisation (11) consiste en un dépôt d'une couche d'accrochage de chrome (43) sur l'une des faces du bloc principal en matériau cristallin et en un dépôt d'une couche d'or (44) sur ladite couche de chrome, la couche d'or constituant ainsi la première électrode principale.

6. Procédé selon l'une des revendications précédentes, caractérisé en ce que le matériau constituant le bloc principal est un monocristal.

7. Procédé selon la revendication 6, caractérisé en ce que le monocristal est du Niobate de Lithium.

8. Procédé selon l'une des revendications précédentes, caractérisé en ce que la fixation (12) de la face métallisée du bloc principal sur le support consiste en un collage à l'aide d'une substance susceptible de se désagréger après durcissement.

9. Procédé selon la revendication 8, caractérisé en ce que la substance est une cire (46).

10. Procédé selon l'une des revendications précédentes, caractérisé en ce que la seconde métallisation (14) consiste en un dépôt d'une couche d'aluminium sur la face opposée du bloc principal, la couche d'aluminium constituant ainsi la seconde électrode principale.

11. Procédé selon la revendication 10, caractérisé en ce que le dépôt de la couche d'aluminium est réalisé par évaporation ou par pulvérisation cathodique sous vide.

12. Procédé selon l'une des revendications 1 à 9, caractérisé en ce que la seconde métallisation (14) consiste en un dépôt d'une couche d'accrochage de chrome (51) sur la face opposée du bloc principal et en un dépôt d'une couche d'or (52) sur ladite couche de chrome, la couche d'or constituant ainsi la seconde électrode principale.

13. Procédé selon l'une des revendications 5 et 12, caractérisé en ce que l'épaisseur de la couche de chrome est de l'ordre de 200 Å et l'épaisseur de la couche d'or est de l'ordre de 1000 Å.

14. Procédé selon l'une des revendications 5, 12 et 13, caractérisé en ce que les dépôts de la couche de chrome et de la couche d'or sont réalisés par pulvérisation cathodique sous vide.

15. Procédé selon l'une des revendications 10 à 12, caractérisé en ce que la seconde métallisation (14) est réalisée partiellement sur la face opposée du bloc principal à l'aide d'un masque en forme de trame, permettant ainsi de limiter ladite métallisation en des endroits déterminés de ladite face du bloc principal.

16. Procédé selon l'une des revendications précédentes, caractérisé en ce que le découpage (15) du bloc principal (30) en blocs élémentaires (60) est réalisé à l'aide d'une scie diamantée.

17. Procédé selon la revendication 9, caractérisé en ce que le retrait (16) du support de fixation consiste en un chauffage de la cire (46) de façon à faire fondre cette dernière.·

18. Transducteurs piézoélectriques comportant chacun un corps en matériau cristallin (61) et deux électrodes (63, 65) disposées respectivement sur deux faces opposées dudit corps, caractérisés en ce que qu'ils sont obtenus par exécution du procédé selon l'une quelconque des revendications précédentes.

19. Utilisation du procédé tel que défini selon l'une des revendications 1 à 17, à la fabrication de lignes à retards électroacoustiques comportant chacune un milieu de propagation (80) sur lequel est fixé au moins un transducteur piézoélectrique (60) transformant une onde électromagnétique en une onde acoustique et réciproquement, caractérisée en ce que ledit procédé comporte de plus les étapes suivantes :
       - une métallisation (22) d'au moins une face du milieu de propagation sur laquelle est destiné à être fixé le transducteur ;
       - un repérage (23) sur la face métallisée du milieu de propagation de l'emplacement (C) du transducteur de façon à obtenir les caractéristiques désirées de la ligne à retard ; et
       - un soudage (24) de la première électrode du transducteur obtenu sur la face métallisée du milieu de propagation, à l'emplacement repéré, permettant ainsi d'obtenir la ligne à retard électroacoustique.

20. Utilisation selon la revendication 19, caractérisée en ce qu'avant la métallisation (22) d'une face du milieu de propagation, le procédé comporte un dressage suivi d'un polissage (21) de ladite face du milieu de propagation.

21. Utilisation selon l'une des revendications 19 ou 20, caractérisée en ce que le soudage (24) est réalisé par thermocompression.

15

22. Utilisation selon l'une des revendications 19 à 21, caractérisée en ce que la métallisation consiste en un dépôt d'une couche d'accrochage de chrome (83) sur la face du milieu de propagation et en un dépôt d'une couche d'or (84) sur ladite couche de chrome, et en ce que les dépôts de la couche de chrome et de la couche d'or sont réalisés par pulvérisation cathodique sous vide.

## FIG_1

10 — DRESSAGE ET POLISSAGE MONOCRISTAL PIEZOELECTRIQUE ET SUPPORT

11 — PREMIERE METALLISATION MONOCRISTAL

12 — FIXATION MONOCRISTAL SUR SUPPORT

13 — MISE A EPAISSEUR MONOCRISTAL

14 — SECONDE METALLISATION MONOCRISTAL

15 — DECOUPAGE EN PUCES

16 — RETRAIT SUPPORT

## FIG_2

21 — DRESSAGE ET POLISSAGE MATERIAU RETARDATEUR

22 — METALLISATION MATERIAU RETARDATEUR

23 — REPERAGE EMPLACEMENT TRANSDUCTEUR SUR MATERIAU RETARDATEUR

24 — SOUDAGE TRANSDUCTEUR SUR MATERIAU RETARDATEUR

FIG_3-b

41

40

FIG_3-a

31

30

FIG_4

44

43

30

FIG_5

e

49

48

30

43

41

46    44

40

FIG_6

e

52

51

30

43

46    44

40

FIG_7

52

55    51

55

46

30

43

44

40

FIG_8

e

65

61

60

63

FIG_9

e    65    66

61

60

63

## FIG_10

## FIG_11

## FIG_12